(19) Europäisches Patentamt
European Patent Office
Office européen des brevets

(11) Veröffentlichungsnummer: **0 096 298**
**A1**

# (12) EUROPÄISCHE PATENTANMELDUNG

(21) Anmeldenummer: 83105185.9

(22) Anmeldetag: 25.05.83

(51) Int. Cl.³: C 01 B 33/02
B 22 D 27/04

(30) Priorität: 28.05.82 DE 3220241

(43) Veröffentlichungstag der Anmeldung:
21.12.83 Patentblatt 83/51

(84) Benannte Vertragsstaaten:
DE FR IT

(71) Anmelder: SIEMENS AKTIENGESELLSCHAFT
Berlin und München Wittelsbacherplatz 2
D-8000 München 2(DE)

(72) Erfinder: Fenzl, Hans Jürgen, Dipl.-Ing.
Soxhletstrasse 6
D-8000 München 40(DE)

(72) Erfinder: Erdmann, Wolfgang Jürgen, Dipl.-Ing.
Erich-Kästner-Strasse 10
D-3016 Seelze 2(DE)

## (54) Verfahren zum Herstellen polykristalliner, für nachfolgendes Zonenschmelzen geeigneter Siliciumstäbe.

(57) Zur Verbesserung des Wirkungsgrades von in der Solartechnik einsetzbaren Siliciums wird billiges im Lichtbogenverfahren gewonnenes Silicium, bevor es einem Zonenziehprozeß unterzogen wird, in Stabform gegossen, wobei die Siliciumschmelze in einen vertikal angeordneten, vorgewärmten Hohlzylinder gefüllt und zum Erstarren gebracht wird, und die Erstarrungswärme praktisch nur über die den Hohlzylinder nach unten abschließende Bodenplatte bei gleichzeitiger Beheizung mindestens von Teilen des Hohlzylinders abgeführt wird, dergestalt, daß ein vom Boden zur freien Stirnfläche des Zylinders verlaufender, die Erstarrung des Siliciums in axialer Richtung steuernder Temperaturgradient erzeugt wird.

FIG 1

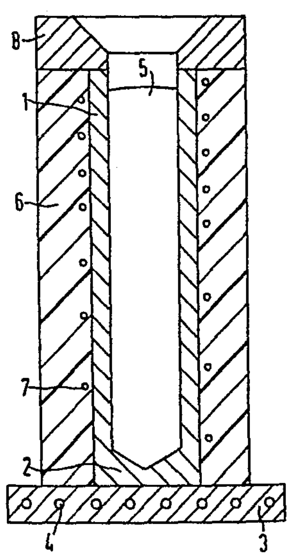


EP 0 096 298 A1

SIEMENS AKTIENGESELLSCHAFT
Berlin und München

Unser Zeichen
82 P 8013 E

Verfahren zum Herstellen polykristalliner, für nachfolgendes Zonenschmelzen geeigneter Siliciumstäbe

Zur großtechnischen Umwandlung von Sonnenenergie in elektrische Energie werden bevorzugt Solarzellen aus kristallinem Silicium eingesetzt. Dabei ist es wünschenswert, reines aber kostengünstiges Silicium einzusetzen, aus dem sich Solarzellen mit einem hohen Wirkungsgrad von beispielsweise mehr als 10 % herstellen lassen.

Zur Herstellung von Solarzellen mit hohen Wirkungsgrad wird heute allgemein hochreines Silicium als Grundmaterial verwendet, das durch thermische Zersetzung von mit Wasserstoff verdünntem, gasförmigen, hochreinen Siliciumverbindungen wie Silicochloroform oder Siliciumtetrachlorid und Abscheidung auf widerstandsbeheizten Siliciumdünnstäben bei einer Temperatur von ca. 1100°C gewonnen wird. Die auf diese Weise hergestellten Siliciumpolystäbe werden durch anschließenden Kristallziehprozeß, z. B. durch tiegelfreies Zonenschmelzen, nachgereinigt, in einen Kristall übergeführt, in Scheiben zersägt, und zu Solarzellen weiterverarbeitet. Dieses Verfahren ist technisch relativ aufwendig und daher für großtechnische Siliciumherstellung zu teuer.

Silicium für technische Anwendungen mit einem zwar wesentlich niedrigeren Reinheitsgrad von beispielsweise 98,& % wird heute großtechnisch durch Reduktion von Quarz mit Kohlenstoff im Lichtbogenofen hergestellt. Dieser Prozeß arbeitet zwar wirtschaftlich, er ist jedoch nur dann zu Herstellung von Solarsilicium geeignet, wenn es gelingt, den bisher erzielten Reinheitsgrad entscheidend zu erhöhen.

Zu diesem Zweck wurde in der deutschen Patentanmeldung P 32 10 141.4 (VPA 82 P 1201 DE) bereits vorgeschlagen, das nach dem Lichtbogenverfahren gewonnene Silicium in Stabform überzuführen und durch anschließendes, tiegelfreies Zonenschmelzen von den störenden Verunreinigungen zu befreien.

Es ist aber nicht so ohne weiteres möglich, diesen Vorschlag zu verifizieren.

Zunächst haben die Versuche mit Eisen- oder Sandformen, wie sie in der Gießtechnik üblich sind, gezeigt, daß diese bei Metallen üblichen Standardverfahren, wegen der hohen Reaktivität des flüssigen Siliciums und der Ausdehnung des Siliciums während des Erstarrens nicht zu brauchbaren Ergebnissen führen.

Andererseits hat sich aber auch gezeigt, daß es nicht so ohne weiteres möglich ist, gegossenes Silicium durch Zonenschmelzen preiswert zu reinigen. Entweder wird im Gegensatz zum durch thermische Zersetzung gewonnenen Silicium dieses mit vielen Lunkern, Bläschen, Einschlüssen und sonstigen Kristallstörungen erhalten oder der Zonenschmelzprozeß muß sehr oft, manchmal mehr als 6 bis 7 mal, wiederholt werden, um ein einigermaßen brauchbares Silicium zu erhalten.

Die Erfindung geht nun von der Erkenntnis aus, daß die technische Qualität des zonengezogenen Solarsiliciums wesentlich verbessert werden kann, wenn das dem Zonenschmelzprozeß zu unterwerfende Silicium nicht nur riß- und lunkerfrei ist. Es soll auch frei von störenden Oberflächenschichten sein und bereits höhere Kristallqualität besitzen. Bei qualitativ höherwertigem Silicium gelingt es sogar mit wenigen Zonenzügen versetzungsfreies einkristallines Silicium zu gewinnen, das selbst für manche anspruchsvolleren Halbleiterbauelemente geeignet ist. Die Erfindung sieht daher vor, beim Herstellen polykristalliner, für nachfolgendes Zonenschmelzen geeignete Siliciumstäbe durch Gießen flüssigen Siliciums in formgebende Behältnisse mit anschließendem Erstarrenlassen den zonenzuschmelzenden Siliciumstab bereits beim Gießen eine so hohe Kristallqualität zu verleihen, daß an die Kristallperfektionierung beim teuren Zonenschmelzen keine zu hohen Anforderungen mehr gestellt werden müssen.

Gemäß vorliegender Erfindung geschieht dies dadurch, daß die Siliciumschmelze in einen vertikal angeordneten, vorgewärmten Hohlzylinder gefüllt und zum Erstarren gebracht wird, wobei die Erstarrungswärme praktisch nur über die dem Hohlzylinder nach unten abschließende Bodenplatte bei gleichzeitiger Beheizung mindestens von Teilen des Hohlzylinders abgeführt wird, dergestalt, daß ein vom Boden zur freien Stirnfläche des Zylinders verlaufender, die Erstarrung des Siliciums in axialer Richtung steuernder Temperaturgradient erzeugt wird.

Besonders gute Ergebnisse werden erhalten, wenn der Hohlzylinder auf eine Temperatur zwischen 1000° und 1400°C vorgewärmt und die Temperatur des Hohlzylinders in der Nähe seiner freien Stirnfläche mindestens während des ersten Drittels des Erstarrungsvorganges auf einen Wert zwischen 800° und 1420° C gehalten wird.

Bei kleineren Durchmessern ist eine Vorerwärmung auf etwa 1400°C erforderlich, während für größere Durchmesser niedrigere Temperaturen bis zu 1000°C ausreichend sind.

Während des Gießverfahrens wird einerseits die Wärme der Schmelze gezielt durch den gekühlten Hohlzylinderboden abgeführt und andererseits der Hohlzylinder längs des Zylinderaußenmantels beheizt. Zweckmäßigerweise ist die Erstarrungsgeschwindigkeit der Schmelze auf etwa 1 bis 10 cm pro Minute eingestellt.

Eine vorteilhafte Weiterbildung der Erfindung sieht vor, die während des Erstarrens der Schmelze auftretende radiale Ausdehnung des Siliciums durch Formgebung des Hohlzylinders aufzunehmen.

Der Gießvorgang selbst kann entweder im Vakuum oder im Schutzgas z. B. bei reduziertem Druck durchgeführt werden. Bei Verwendung von Argon hat sich ein Partialdruck von 10 bis 20 Torr als besonders günstig erwiesen.

Die Vorrichtung zur Durchführung des erfindungsgemäßen Verfahrens besteht im wesentlichen aus einem vertikal angeordnetem Hohlzylinder aus Graphit, dessen Innenmantel eine die Siliciumcarbidbildung vermeidende Auskleidung besitzt, an dessen die Unterseite des Hohlzylinders abschließenden Boden eine kühlbare Grundplatte vorgesehen ist; außerhalb des Hohlzylinders ist eine die Erstarrung der Schmelze in Längsrichtung des Zylinders steuernde Heizeinrichtung angeordnet.

Die Grundplatte besteht vorzugsweise aus Kupfer oder aus Eisen bzw. Edelstahl und hat Bohrungen bzw. Führungen für das Kühlwasser.

Der Hohlzylinder hat bei einer Länge von 50 bis 150 cm, einen Innendurchmesser von 30 bis 100 mm und eine Wandstärke, die zwischen 10 und 30, vorzugsweise bei 20 mm liegt.

Die während des Erstarrens der Schmelze auftretende radiale Ausdehnung des Siliciums wird dadurch aufgenommen, daß der Graphithohlzylinder aus wenigstens 3 elastisch miteinander verbundenen Teilzylindern besteht. Die Graphiteigenschaften sind dabei so zu wählen, daß sie den Materialparametern des Siliciums weitgehend entsprechen. Zur Vermeidung einer Siliciumcarbidbildung ist der Innenmantel des Graphithohlzylinders z. B. mit Quarzsand ausgekleidet oder er besitzt eine nachverdichtete Graphitoberfläche mit Dichten von mehr als 1,85 $g/cm^3$.

Für die gemäß der Erfindung vorgesehene Zusatzheizung eignet sich sowohl eine Induktions- als auch eine Widerstandsheizung. In vielen Fällen reicht es aus, wenn die Heizeinrichtung nur im Bereich der freien Stirnfläche des Hohlzylinders vorgesehen ist. Im einfachsten Fall wird eine Leistungsreduktion der Heizeinrichtung durch sukzessives Entfernen des Hohlzylinders aus dem Heizungsbereich erhalten.

Die Erfindung wird anhand von vier, als Ausführungsbeispiele zu wertende Figuren näher erläutert. Kernstück der Gießform ist, wie aus der Figur 1 hervorgeht, der aus Graphit bestehende vertikal angeordnete Hohlzylinder 1, der auf seinem Innenmantel eine in der Zeichnung nicht näher dargestellte, die Siliciumcarbidbildung vermeidende Graphitschicht trägt. Der den Hohlzylinder nach unten abschließende Boden 2 ist thermisch mit der Edelstahlplatte 3 verbunden, diese Grundplatte ist mit Bohrungen bzw. Führungen 4 für das erforderliche Kühlwasser ausgestattet.

Das in einem Lichtbogenofen erzeugte schmelzflüssige Silicium wird bei einer Temperatur zwischen 1420° und 1470°C, vorzugsweise bei 1430°C, in einem Zuge aus einem in der Zeichnung nicht dargestellten Vorratsgefäß in die Kokille 1, 2 gegossen, die eine Länge von 100 cm, einen Innendurchmesser von 60 mm und eine Wandstärke von 20 mm hat, sie wurde vor dem Gießvorgang auf etwa 1200°C vorgewärmt.

Nach oben ist die Gußvorrichtung durch eine trichterförmig ausgebildete, ebenfalls aus Graphit bestehende Einfüllhilfe 8 abgeschlossen.

Wesentlich ist bei dem erfindungsgemäßen Verfahren, daß die Erstarrung der Siliciumschmelze eindimensional gesteuert wird, so daß das Silicium 5 gerichtet vom Boden 2 zum Kopf hin, also zur freien Stirnfläche des Hohlzylinders 1 hin, erstarrt. Erreichen läßt sich dies durch die kühlbare Unterlage 3 auf die die Kokille 1, 2 gestellt wird und durch eine Beheizung des Hohlzylinders.

Als Heizeinrichtung dient bei dem Ausführungsbeispiel nach Figur 1 ein die Kokille konzentrisch umschließendes Keramikrohr 6, in das Heizdrähte 7 für eine Widerstandsheizung dieses Rohres 6 eingelassen sind. Die Heizleistung ist um eine Abkühlung der Schmelze zu ermöglichen in ihrer Intensität steuerbar. Die Heizdrähte haben aber darüberhinaus noch unterschiedliche Abstände um eine Temperaturverteilung wie in Figur 2 angedeutet zu realisieren, so daß der Kokillenkopf mit etwa 1000°C am heißesten ist und daher am Schluß erstarrt. Figur 2 zeigt schematisch den erzeugten, axialen Temperaturgradienten also die Verteilung der Temperatur T längs der Kokille.

Wenn die Heizeinrichtung 6, 7 bewegbar ausgelegt ist, kann sie in axialer Richtung abgezogen werden, damit neben der sonst üblichen Heizleistungsreduktion die gemäß vorliegender Erfindung erhaltene gerichtete Erstarrung unterstützt bzw. gefördert wird.

Die Kokillenheizung kann gemäß einem anderen Ausführungsbeispiel auch durch hochfrequente Induktionsheizung erfolgen, wobei diese wahlweise nur am oberen Ende der Kokille angeordnet sein kann.

Mit den unterschiedlichen Parametern der Heizleistungssteuerung kann auch die Abkühlgeschwindigkeit gesteuert und auf optimale Werte gebracht werden. Nach unten begrenzt die Ökonomie die einzuhaltende Abkühlgeschwindigkeit - das erzeugte Silicium muß bekanntlich sehr billig werden - während die Abkühlgeschwindigkeit nach oben durch die maximale Kristallwachstumsgeschwindigkeit begrenzt ist. Bei einer möglichen Abkühlgeschwindigkeit von etwa 1 cm pro Minute werden in Abhängigkeit von der Stablänge zur gesteuerten Abkühlung nur ein bis zwei Stunden benötigt. Es ist dies eine Geschwindigkeit, bei der auch die Schlacken und sonstigen festen und groben Verunreinigungen wie Kohle, Siliciumcarbid- und Quarzstückchen genügend Zeit haben mit der Erstarrungsfront zur freien Oberfläche nach oben zu schwimmen.

Die Figuren 3 und 4 zeigen eine andere vereinfacht dargestellte erfindungsgemäße Gießkokillen. Hier ist die Lösung des Problems der radialen Ausdehnung des Siliciums während des Erstarrens durch entsprechende Formgebung des Gießgefäßes sichtbar gemacht. In Figur 3 ist bei entfernter Grundplatte das Gießgefäß von unten her dargestellt. Das Graphitgefäß 1 besteht aus den drei Teilen 9, 10 und 11 die über elastische Mittel, z. B. mit Klammern, miteinander verbunden sind. Im einfachsten Fall genügt es, die drei Gefäßteile mit einem verformbaren Draht zu umwickeln. Jedes der drei Teilgefäße besitzt Bohrungen vom Boden her, die, wie aus der den Schnitt AB wiedergebenden Figur 4 ersichtlich ist, zwecks Aufnahme von Heizstäben parallel zur Kokillenachse verlaufen. Zur Temperaturüberwachung besitzt Segment 11 eine Zusatzbohrung, die ein Thermoelement aufzunehmen gestattet.

Patentansprüche

1. Verfahren zum Herstellen polykristalliner, für nachfolgendes Zonenschmelzen geeigneter Siliciumstäbe durch Gießen flüssigen Siliciums in formgebende Behältnisse mit anschließendem Erstarrenlassen, dadurch gekennzeichnet, daß die Siliciumschmelze in einen vertikal angeordneten, vorgewärmten Hohlzylinder gefüllt und zum Erstarren gebracht wird, daß dabei die Erstarrungswärme praktisch nur über die den Hohlzylinder nach unten abschließende Bodenplatte bei gleichzeitiger Beheizung mindestens von Teilen des Hohlzylinders abgeführt wird, dergestalt, daß ein vom Boden zur freien Stirnfläche des Zylinders verlaufender, die Erstarrung des Siliciums in axialer Richtung steuernder Temperaturgradient erzeugt wird.

2. Verfahren nach Anspruch 1, dadurch gekennzeichnet, daß der Hohlzylinder auf eine Temperatur zwischen 1000° und 1400°C vorgewärmt wird.

3. Verfahren nach Anspruch 1 und 2, dadurch gekennzeichnet, daß die Temperatur des Hohlzylinders in der Nähe seiner freien Stirnflächen mindestens während des ersten Drittels des Erstarrungsvorganges auf einen Wert zwischen 800° und 1420° C gehalten wird.

4. Verfahren nach wenigstens einem der Ansprüche 1 bis 3, dadurch gekennzeichnet, daß die Wärme der Schmelze gezielt nach dem Hohlzylinderboden abgeführt wird.

5. Verfahren nach wenigstens einem der Ansprüche 1 bis 4, dadurch gekennzeichnet, daß der Hohlzylinderboden gekühlt wird.

6. Verfahren nach wenigstens einem der Ansprüche 1 bis 5, dadurch gekennzeichnet, daß die Erstarrungsgeschwindigkeit der Siliciumschmelze auf etwa 1 bis 10 cm pro Minute eingestellt wird.

7. Verfahren nach wenigstens einem der Ansprüche 1 bis 6, dadurch gekennzeichnet, daß die während des Erstarrens der Schmelze auftretende radiale Ausdehnung des Siliciums durch Formgebung des Hohlzylinders aufgenommen wird.

8. Verfahren nach wenigstens einem der Ansprüche 1 bis 7, dadurch gekennzeichnet, daß der Gießvorgang im Vakuum durchgeführt wird.

9. Verfahren nach wenigstens einem der Ansprüche 1 bis 7, dadurch gekennzeichnet, daß der Gießvorgang im Schutzgas, z. B. Argon, bei reduziertem Druck durchgeführt wird.

10. Verfahren nach Anspruch 9, dadurch gekennzeichnet, daß der Gießvorgang bei einem Argonpartialdruck von 10 bis 20 Torr durchgeführt wird.

11. Vorrichtung zur Durchführung des Verfahrens nach Anspruch 1 bis 10, dadurch gekennzeichnet, daß ein vertikal angeordneter aus Graphit bestehender Hohlzylinder Verwendung findet, dessen Innenmantel eine die Siliciumcarbidbildung vermeidende Auskleidung besitzt, an dessen die Unterseite des Hohlzylinders abschließenden Boden eine kühlbare Grundplatte vorgesehen ist und daß außerhalb des Hohlzylinders eine die Erstarrung der Schmelze in Längsrichtung des Zylinders steuernde Heizeinrichtung angeordnet ist.

12. Vorrichtung nach Anspruch 11, d a d u r c h g e k e n n z e i c h n e t, daß der Hohlzylinder bei einer Länge von 50 bis 150 cm einen Innendurchmesser von 30 bis 100 mm besitzt.

13. Anordnung nach Anspruch 11 und 12, d a d u r c h g e k e n n z e i c h n e t, daß die Wandstärke des Hohlzylinders zwischen 10 und 30 mm, vorzugsweise bei 20 mm liegt.

14. Vorrichtung nach wenigstens einem der Ansprüche 11 bis 13, d a d u r c h g e k e n n z e i c h n e t, daß der Graphithohlzylinder aus wenigstens drei elastisch miteinander verbundenen Teilzylindern besteht.

15. Vorrichtung nach wenigstens einem der Ansprüche 11 bis 14, d a d u r c h g e k e n n z e i c h n e t, daß der Innenmantel des Graphithohlzylinders mit Quarzsand ausgekleidet ist.

16. Vorrichtung nach wenigstens einem der Ansprüche 11 bis 14, d a d u r c h g e k e n n z e i c h n e t, daß der Innenmantel des Graphithohlzylinders eine vergütete Graphitoberfläche besitzt.

17. Vorrichtung nach wenigstens einem der Ansprüche 11 bis 16, d a d u r c h g e k e n n z e i c h n e t, daß die Grundplatte Kühlwasserführungen aufweist.

18. Vorrichtung nach wenigstens einem der Ansprüche 11 bis 17, d a d u r c h g e k e n n z e i c h n e t, daß als Heizeinrichtung eine Induktionsheizung vorgesehen ist.

19. Vorrichtung nach wenigstens einem der Ansprüche 1 bis 17, d a d u r c h g e k e n n z e i c h n e t, daß als Heizeinrichtung eine Widerstandsheizung vorgesehen ist.

20.Vorrichtung nach wenigstens einem der Ansprüche 1 bis 19, d a d u r c h g e k e n n z e i c h n e t, daß die Heizeinrichtung nur im Bereich der freien Stirnfläche des Hohlzylinders vorgesehen ist.

21. Vorrichtung nach wenigstens einem der Ansprüche 11 bis 20, d a d u r c h g e k e n n z e i c h n e t, daß die Leistungsreduktion der Heizeinrichtung durch sukzessives Entfernen des Hohlzylinders aus dem Heizungsbereich erfolgt.

0096298

FIG 1

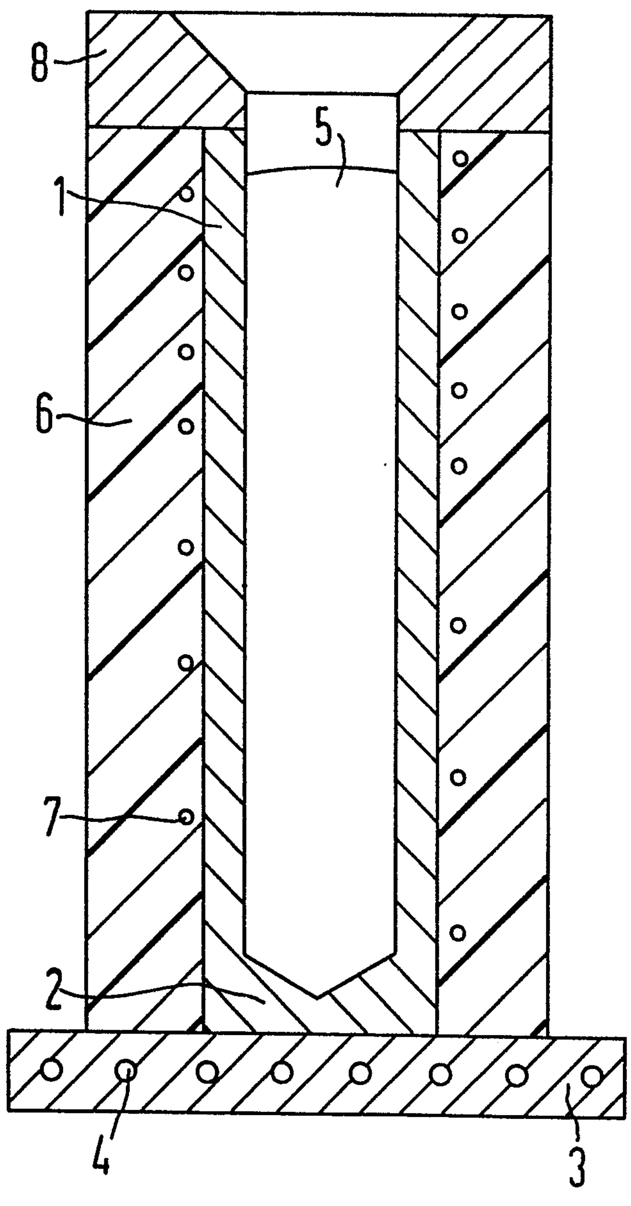


FIG 2

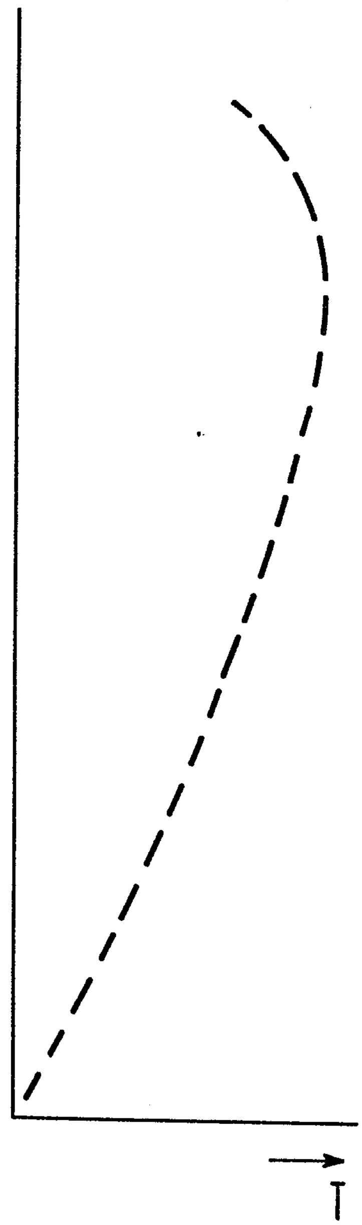

0096298

FIG 3

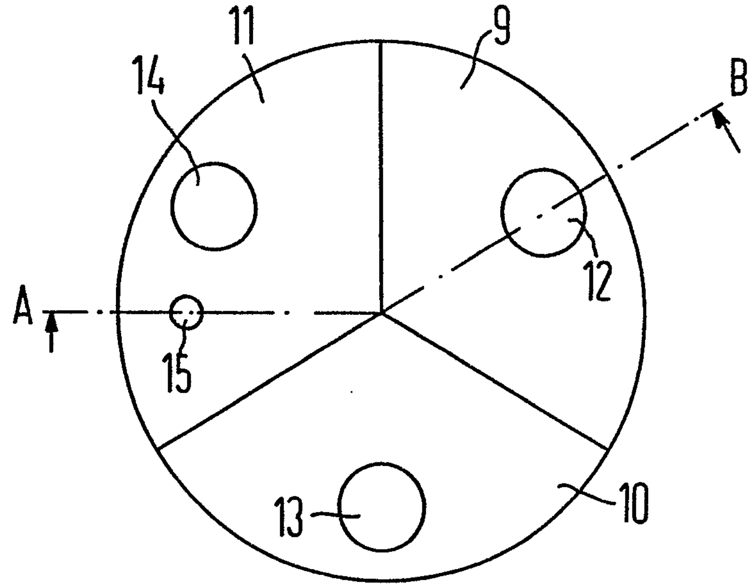


FIG 4

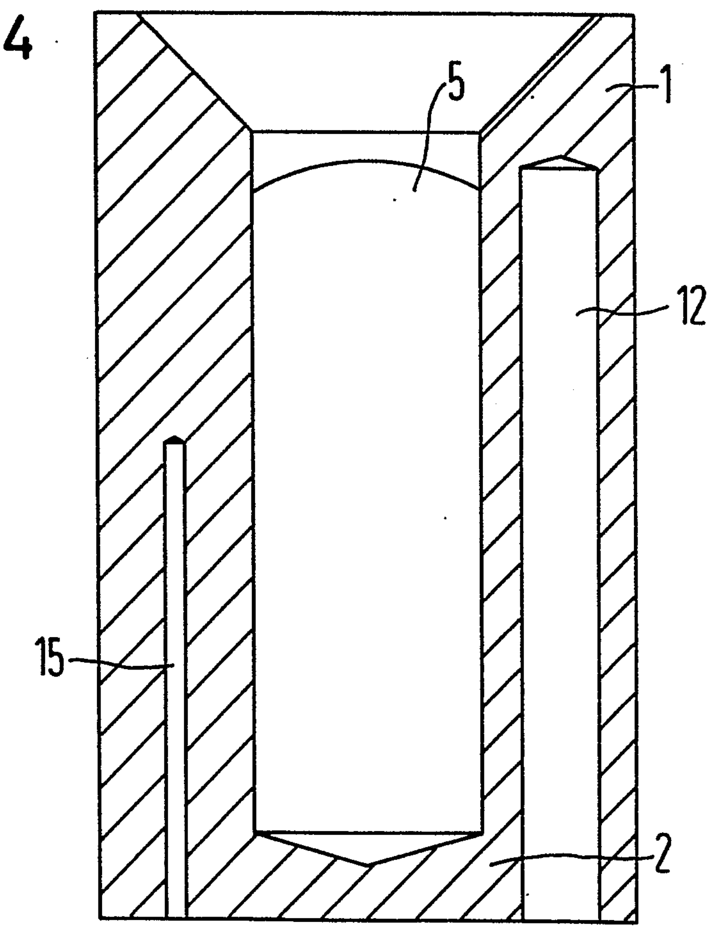

Europäisches Patentamt

# EUROPÄISCHER RECHERCHENBERICHT

0096298
Nummer der Anmeldung

EP 83 10 5185

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| Y | EP-A-0 002 135 (UNION CARBIDE)<br>* Anspruch 2 * | 1,4,5,<br>8,11 | C 01 B 33/02<br>B 22 D 27/04 |
| X | * Seite 13, Absatz 2; Seite 14, Zeile 35 - Seite 15, Zeile 30 *<br>--- | 1,9,15<br>,21 | |
| Y | US-A-3 532 155 (L.I. KANE et al.) * Anspruch 1 *<br>--- | 1,4,5,<br>8 | |
| Y | FONDERIE, Nr. 12, Februar 1982, Paris M.H. KHAN "La solidification dirigée", Seiten 17-23 | 1,11 | |
| X | FONDERIE, Nr. 12, Februar 1982 * Figuren 1, 2 *<br>--- | 1,11,<br>17,18,<br>19 | **RECHERCHIERTE SACHGEBIETE (Int. Cl. 3)**<br>B 22 D 27/00<br>C 01 B 33/00<br>C 30 B 21/00 |
| X | DE-B-2 405 598 (GEBR. BÖHLER)<br>* Anspruch 1 *<br>--- | 1,11,<br>14 | |
| A | US-A-3 857 436 (D.A. PETROV et al.)<br>--- | | |
| A | US-A-4 298 423 (J. LINDMAYER)<br>--- -/- | | |

Der vorliegende Recherchenbericht wurde für alle Patentansprüche erstellt.

| Recherchenort | Abschlußdatum der Recherche | Prüfer |
|---|---|---|
| BERLIN | 05-09-1983 | KESTEN W |

**KATEGORIE DER GENANNTEN DOKUMENTEN**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82

Europäisches Patentamt

**EUROPÄISCHER RECHERCHENBERICHT**

0096298
Nummer der Anmeldung

EP 83 10 5185

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | FR-A-2 494 416 (SEMIX)<br>----- | | |
| | | | RECHERCHIERTE SACHGEBIETE (Int. Cl. 3) |

Der vorliegende Recherchenbericht wurde für alle Patentansprüche erstellt.

| Recherchenort | Abschlußdatum der Recherche | Prüfer |
|---|---|---|
| BERLIN | 05-09-1983 | KESTEN W |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82